(19) Europäisches Patentamt / European Patent Office / Office européen des brevets

(11) **EP 4 155 738 B1**

(12) **FASCICULE DE BREVET EUROPEEN**

(45) Date de publication et mention
de la délivrance du brevet:
**28.02.2024 Bulletin 2024/09**

(21) Numéro de dépôt: **22197313.4**

(22) Date de dépôt: **23.09.2022**

(51) Classification Internationale des Brevets (IPC):
**G01R 19/25** *(2006.01)* **G01R 22/06** *(2006.01)*
**G01R 31/58** *(2020.01)* **G01R 31/69** *(2020.01)*

(52) Classification Coopérative des Brevets (CPC):
**G01R 19/2513; G01R 22/06; G01R 31/58;
G01R 31/69**

(54) **DETECTION D'UN SERRAGE DEFECTUEUX**

ERKENNUNG EINER FEHLERHAFTEN KLEMME

DETECTING DEFECTIVE CLAMPING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.09.2021 FR 2110196**

(43) Date de publication de la demande:
**29.03.2023 Bulletin 2023/13**

(73) Titulaire: **Sagemcom Energy & Telecom SAS
92270 Bois-Colombes (FR)**

(72) Inventeurs:
• **TEBOULLE, Henri
92500 RUEIL MALMAISON (FR)**
• **ENGEL, Philippe
92500 RUEIL MALMAISON (FR)**

(74) Mandataire: **Cabinet Boettcher
5, rue de Vienne
75008 Paris (FR)**

(56) Documents cités:
**EP-A1- 0 430 823 WO-A1-2015/179908**

**Description**

L'invention concerne le domaine des compteurs électriques.

ARRIERE PLAN DE L'INVENTION

Il peut arriver qu'un installateur serre mal un ou des câbles d'arrivée électrique (phase(s) ou neutre) lors de l'installation d'un compteur électrique chez un abonné (particulier ou industriel). Le problème de serrage peut aussi survenir longtemps après l'installation.

Or, le serrage défectueux d'un câble au niveau d'une borne d'entrée du compteur peut conduire à un échauffement qui lui-même est susceptible de provoquer un incendie du compteur.

Il a donc été naturellement envisagé, pour détecter un serrage défectueux et alerter l'installateur et/ou le gestionnaire du réseau, d'intégrer un capteur de température à l'intérieur du compteur pour mesurer la température à proximité des bornes d'entrée. Cette solution n'est cependant pas parfaitement satisfaisante.

Cette solution requiert en effet l'intégration d'au moins un nouveau capteur et de composants de mesure associés, de sorte qu'elle est relativement complexe et coûteuse à mettre en oeuvre.

De plus, la hausse anormale de température détectée par le capteur de température dans le compteur peut être provoquée par un serrage défectueux, mais peut aussi avoir une autre origine, par exemple un échauffement d'un organe de coupure (*breaker*) monté sur une phase à l'intérieur du compteur. Il n'y a pas de dichotomie entre un échauffement dû à l'organe de coupure et un échauffement dû à un câble mal serré, de sorte que l'origine précise de l'échauffement ne peut pas être détectée. Cette solution ne permet donc pas non plus de déterminer la borne d'entrée qui est concernée par le serrage défectueux. Les documents WO2015/179908 et EP0430823 divulguent un état de la technique pertinent.

OBJET DE L'INVENTION

L'invention a pour objet de permettre de détecter le serrage défectueux d'un câble au niveau d'une borne d'entrée d'un compteur, ladite détection étant rapide, simple, peu coûteuse à mettre en oeuvre, et ne laissant subsister aucun doute sur l'origine du défaut.

RESUME DE L'INVENTION

En vue de la réalisation de ce but, on propose un compteur électrique, agencé pour mesurer une énergie électrique fournie par une source, comportant :

- au moins une borne d'entrée, chaque borne d'entrée étant agencée pour être connectée à la source par un câble ;

- au moins un capteur de tension et au moins un capteur de courant agencés pour produire respectivement, depuis l'intérieur du compteur électrique, des mesures de tension pour évaluer une tension source fournie par la source, et des mesures de courant pour évaluer un courant source fourni par la source ;
- une unité de traitement agencée pour :

  o acquérir les mesures de tension et les mesures de courant, et détecter au moins une séquence prédéfinie comprenant une première période, au cours de laquelle le courant source est inférieur à un premier seuil de courant prédéfini, et une deuxième période, au cours de laquelle le courant source est supérieur à un deuxième seuil de courant prédéfini, qui est supérieur au premier seuil de courant prédéfini ;
  o acquérir, pour chaque séquence prédéfinie, au moins une première mesure de tension pendant la première période et au moins une deuxième mesure de tension pendant la deuxième période ;
  o détecter un serrage défectueux d'au moins un câble au niveau de la borne d'entrée connectée audit câble lorsque, pour au moins une séquence prédéfinie, au moins une valeur de détection représentative d'une différence entre une première mesure de tension et une deuxième mesure de tension est supérieure ou égale à un seuil de tension.

Le compteur électrique selon l'invention ne nécessite pas de composants matériels additionnels pour détecter le serrage défectueux, de sorte que l'invention est à la fois simple et peu coûteuse à mettre en oeuvre.

Le critère de détection se base sur l'évolution de la tension source mesurée (en aval de la borne d'entrée) lorsque le courant source passe d'un niveau faible à un niveau élevé, ou inversement. Cette évolution dépend de la valeur d'impédance de la borne d'entrée, qui dépend elle-même de la qualité du serrage du câble. L'origine du défaut constaté est donc incontestable. Le serrage défectueux peut être détecté dès la survenue d'une séquence prédéterminée, et donc très rapidement.

On propose de plus un compteur électrique tel que précédemment décrit, dans lequel l'unité de traitement est agencée pour détecter une séquence prédéfinie seulement lorsqu'une durée séparant la première période de la deuxième période est inférieure à un seuil temporel prédéfini.

On propose de plus un compteur électrique tel que précédemment décrit, dans lequel le seuil de tension est défini en fonction d'une première mesure de courant réalisée au cours de la première période et d'une deuxième mesure de courant réalisée au cours de la deuxième période.

On propose de plus un compteur électrique tel que précédemment décrit, dans lequel on a :

$$SV = a*(I2-I1),$$

où SV est le seuil de tension, a est un paramètre, I1 est la première mesure de courant réalisée au cours de la première période et I2 est la deuxième mesure de courant réalisée au cours de la deuxième période.

On propose de plus un compteur électrique tel que précédemment décrit, dans lequel le paramètre a est défini en fonction du premier seuil de courant prédéfini et du deuxième seuil de courant prédéfini.

On propose de plus un compteur électrique tel que précédemment décrit, dans lequel l'unité de traitement est agencée pour détecter le serrage défectueux lorsqu'un premier nombre prédéfini d'une pluralité de valeurs de détection, obtenues au cours d'une même séquence prédéfinie, sont supérieures au seuil de tension.

On propose de plus un compteur électrique tel que précédemment décrit, dans lequel l'unité de traitement est agencée pour détecter le serrage défectueux lorsque plusieurs valeurs de détection, obtenues pour un deuxième nombre prédéfini de séquences prédéfinies successives, sont supérieures au seuil de tension.

On propose de plus un compteur électrique tel que précédemment décrit, dans lequel le premier seuil de courant prédéfini est compris entre 2,5A et 7,5A, et le deuxième seuil de courant prédéfini est compris entre 20A et 60A.

On propose de plus un compteur électrique tel que précédemment décrit, la source comprenant trois phases, le compteur électrique étant un compteur triphasé comprenant trois bornes d'entrée agencées pour être connectées chacune à une phase via un câble de phase, le compteur électrique comprenant, pour chaque câble de phase, un capteur de tension agencé pour produire des mesures de tension pour évaluer la tension source présente sur ledit câble de phase, et un capteur de courant agencé pour produire des mesures de courant pour évaluer le courant source circulant sur ledit câble de phase, l'unité de traitement étant agencée, pour chaque câble de phase, pour détecter un serrage défectueux dudit câble de phase au niveau de la borne d'entrée connectée audit câble de phase à partir des mesures de tension et des mesures de courant produites par le capteur de tension et le capteur de courant associés.

On propose de plus un compteur électrique tel que précédemment décrit, la source comprenant en outre un neutre, le compteur électrique comprenant en outre une borne d'entrée agencée pour être connectée au neutre via un câble de neutre, l'unité de traitement étant agencée pour :

- lorsqu'elle détecte un ou des serrages défectueux d'un ou de deux câbles de phase au niveau de la ou des bornes d'entrée connectées audit ou auxdits câbles de phase, localiser un serrage défectueux réel au niveau de ladite ou desdites bornes d'entrée ;
- lorsqu'elle détecte simultanément des serrages défectueux des trois câbles de phase au niveau des trois bornes d'entrée connectées auxdits câbles de phase, localiser un serrage défectueux réel au niveau de la borne d'entrée connectée au câble de neutre.

On propose de plus un compteur électrique tel que précédemment décrit, la source comprenant une phase et un neutre, le compteur électrique étant un compteur monophasé comprenant une borne d'entrée agencée pour être connectée à la phase par un câble de phase et une borne d'entrée agencée pour être connectée au neutre par un câble de neutre, le compteur électrique comprenant un capteur de tension agencé pour produire des mesures de tension pour évaluer la tension source présente sur ledit câble de neutre, et un capteur de courant agencé pour produire des mesures de courant pour évaluer le courant source circulant sur ledit câble de phase, l'unité de traitement étant agencée pour détecter un serrage défectueux à partir des mesures de tension produites par le capteur de tension et des mesures de courant produites par le capteur de courant.

On propose de plus un compteur électrique tel que précédemment décrit, la source étant un réseau de distribution d'énergie électrique.

On propose de plus un compteur électrique tel que précédemment décrit, la source étant une installation d'un abonné productrice d'énergie électrique.

On propose de plus un procédé de détection, mis en oeuvre par une unité de traitement d'un compteur électrique tel que précédemment décrit, et comprenant les étapes de :

○ acquérir les mesures de tension et les mesures de courant, et détecter au moins une séquence prédéfinie comprenant une première période, au cours de laquelle le courant source est inférieur à un premier seuil de courant prédéfini, et une deuxième période, au cours de laquelle le courant source est supérieur à un deuxième seuil de courant prédéfini, qui est supérieur au premier seuil de courant prédéfini ;
○ acquérir, pour chaque séquence prédéfinie, au moins une première mesure de tension pendant la première période et au moins une deuxième mesure de tension pendant la deuxième période ;
○ détecter un serrage défectueux d'au moins un câble au niveau de la borne d'entrée connectée audit câble lorsque, pour au moins une séquence prédéfinie, au moins une valeur de détection représentative d'une différence entre une première mesure de tension et une deuxième mesure de tension est supérieure ou égale à un seuil de tension prédéfini.

On propose de plus un programme d'ordinateur comprenant des instructions qui conduisent l'unité de traitement du compteur électrique tel que précédemment décrit à exécuter les étapes du procédé de détection tel que précédemment décrit.

On propose de plus un support d'enregistrement lisible par ordinateur, sur lequel est enregistré le programme d'ordinateur tel que précédemment décrit.
L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente un compteur électrique selon un premier mode de réalisation de l'invention, le compteur étant un compteur triphasé dans une configuration en quatre fils ;
[Fig. 2] la figure 2 représente un schéma électrique du compteur de la figure 1 (une seule phase étant représentée) ;
[Fig. 3] la figure 3 représente un compteur électrique selon un deuxième mode de réalisation de l'invention, le compteur étant un compteur triphasé dans une configuration en trois fils ;
[Fig. 4] la figure 4 représente un compteur électrique selon un troisième mode de réalisation de l'invention, le compteur étant un compteur monophasé ;
[Fig. 5] la figure 5 représente un schéma électrique du compteur de la figure 4.

DESCRIPTION DETAILLEE DE L'INVENTION

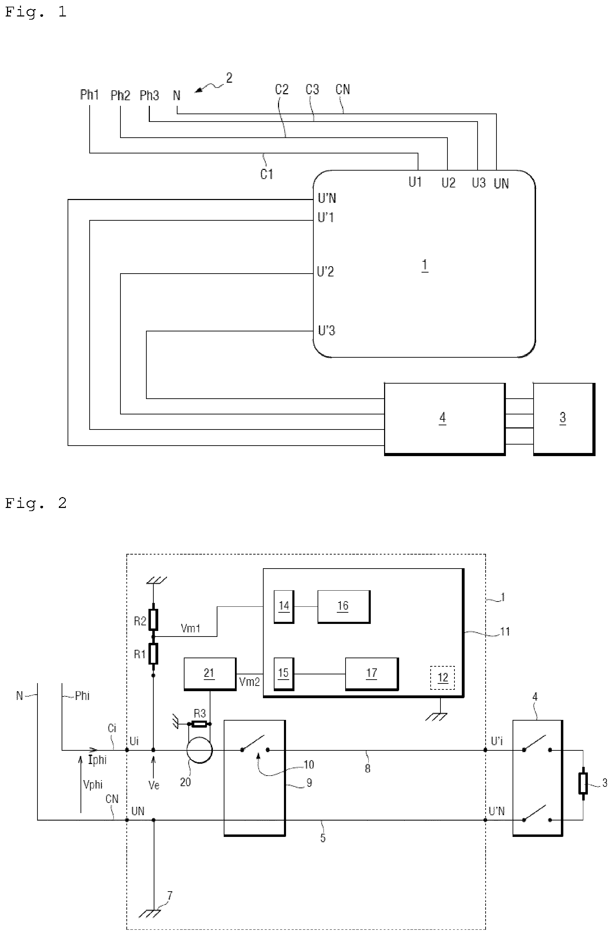

En référence à la figure 1, un compteur électrique 1 selon un premier mode de réalisation de l'invention est un compteur triphasé, qui est agencé selon une configuration en quatre fils dans un cas standard, résidentiel ou industriel, à raccordement direct.
Le compteur 1 est destiné à mesurer une énergie électrique fournie par une source, en l'occurrence par un réseau de distribution 2, à l'installation électrique 3 d'un abonné.
Le réseau de distribution 2 comporte trois phases Ph1, Ph2, Ph3 et un neutre N. Le compteur 1 récupère les phases et le neutre du réseau 2 pour réaliser les mesures métrologiques.
Un disjoncteur 4 est positionné à la frontière entre le réseau de distribution 2 et l'installation 3. Le disjoncteur 4, qui peut être actionné par l'abonné, a notamment pour rôle de protéger l'installation 3 en s'ouvrant lorsqu'un sur-courant, résultant par exemple d'un court-circuit en aval du disjoncteur 4, survient sur le réseau de distribution 2. Ici, par « en aval », on entend du côté de l'installation 3 et par « en amont », on entend du côté du réseau de distribution 2.
Le compteur 1 comprend trois bornes d'entrée U1, U2, U3 reliées chacune à l'une des phases Ph1, Ph2, Ph3 du réseau 2 par un câble de phase C1, C2, C3, et une borne d'entrée UN reliée au neutre N par un câble de neutre CN.

Le compteur 1 comprend de plus quatre bornes de sortie U'1, U'2, U'3, U'N reliées au disjoncteur 4, qui est lui-même relié à l'installation 3.
En référence à la figure 2, le compteur 1 comporte un conducteur de neutre 5 relié à la borne d'entrée UN. Le conducteur de neutre 5 est relié à une masse électrique 7 du compteur 1.
Pour chaque phase Phi (i variant de 1 à 3), le compteur 1 comporte un conducteur de phase 8 relié à la borne d'entrée Ui.
Le compteur 1 comprend de plus un organe de coupure 9 qui comprend, pour chaque conducteur de phase 8, un interrupteur 10 distinct monté sur ledit conducteur de phase 8. L'organe de coupure 9 est notamment utilisé pour couper ou rétablir à distance l'alimentation de l'installation 3 (symbolisée ici par une charge) en cas, par exemple, de résiliation de l'abonnement ou de non-respect du contrat d'abonnement.
Le compteur 1 comporte de plus une partie applicative et une partie métrologie.
La partie applicative comprend un microcontrôleur application (non représenté).
La partie métrologie comprend un microcontrôleur de métrologie 11, dont la fonction primaire est de produire des mesures d'un certain nombre de paramètres permettant d'évaluer la consommation électrique de l'installation 3.
Le microcontrôleur 11 est de plus adapté à exécuter des instructions d'un programme pour mettre en oeuvre le procédé de détection qui va être décrit. Les instructions du programme sont stockées dans une mémoire 12, qui est intégrée dans ou reliée au microcontrôleur 11.
Le microcontrôleur 11 intègre un premier convertisseur analogique numérique (CAN) 14, un deuxième CAN 15, un module de mesure de tension 16 et un module de mesure de courant 17.
Pour chaque phase Phi, la partie métrologie comprend un capteur de tension agencé pour produire des mesures de tension pour évaluer une tension source Vphi présente sur le câble de phase Ci.
Le capteur de tension comprend ici un pont diviseur de tension comprenant une première résistance de mesure R1 et une deuxième résistance de mesure R2. La première résistance de mesure R1 a une première borne reliée au conducteur de phase 8 à proximité (et en aval) de la borne d'entrée Ui. La deuxième résistance de mesure R2 a une première borne reliée à la masse électrique 7. La deuxième borne de la première résistance de mesure R1 et la deuxième borne de la deuxième résistance de mesure R2 sont reliées entre elles et à une entrée du microcontrôleur 11 à laquelle est reliée une entrée du premier CAN 14. Le premier CAN 14 comprend donc (au moins) trois entrées, c'est-à-dire une entrée par phase Phi.
La tension Vm1, qui est mesurée par le premier CAN 14, est une tension image de la tension d'entrée Ve (tension au niveau de la borne d'entrée Ui en aval de celle-ci) et permet d'évaluer la tension source Vphi.

Le niveau de la tension Vm1 est adapté (grâce au pont diviseur R1, R2) afin d'éviter des saturations au niveau du premier CAN 14, et de manière à appliquer en entrée du premier CAN 14 des signaux ayant des niveaux significatifs (et correspondant à la plage d'entrée du premier CAN 14).

Le premier CAN 14 numérise donc la tension Vm1. Le module de mesure de tension 16 produit, à partir des échantillons produits par le premier CAN 14, des mesures de tension (efficace) permettant d'évaluer la tension d'entrée Ve. Le microcontrôleur 15 utilise les mesures de tension pour évaluer la tension source Vphi fournie par le réseau 2 bien que, comme on le verra plus bas, la tension d'entrée Ve ne soit pas exactement égale à la tension source Vphi.

Pour chaque phase Phi, la partie métrologie comprend aussi un capteur de courant agencé pour produire des mesures de courant représentatives d'un courant source Iphi circulant sur le conducteur de phase Ci.

Le capteur de courant comprend un tore 20 monté sur le conducteur de phase 8 en amont de l'interrupteur 10 de l'organe de coupure 9. Une troisième résistance de mesure R3 est montée entre les bornes de sortie du tore 20.

Les composants métrologiques comprennent aussi une chaîne de mesure de courant 21 présentant un gain connu. La chaîne de mesure de courant 21 est reliée à une borne de la troisième résistance de mesure R3, l'autre borne de la résistance de mesure étant reliée à la masse 7.

La sortie de la chaîne de mesure de courant 21 est reliée à une entrée du microcontrôleur 11 à laquelle est reliée une entrée du deuxième CAN 15. Le deuxième CAN 15 comprend donc (au moins) trois entrées, c'est à dire une entrée par phase Phi.

La tension Vm2 en sortie de la chaîne de mesure de courant 21 est une tension image du courant source Iphi.

Le niveau de la tension Vm2 est adapté (grâce au gain de la chaîne de mesure de courant 21) afin d'éviter des saturations au niveau du deuxième CAN 15, et de manière à appliquer en entrée du deuxième CAN 15 des signaux ayant des niveaux significatifs (et correspondant à la plage d'entrée du deuxième CAN 15).

Le deuxième CAN 15 numérise la tension Vm2. Le module de mesure de courant 17 produit, à partir des échantillons produits par le deuxième CAN 15, des mesures de courant permettant d'évaluer le courant source Iphi.

Ici, le module de mesure de tension 16 et le module de mesure de courant 17 produisent chacun, pour chaque phase, une mesure toutes les secondes.

On décrit maintenant plus précisément la manière dont le compteur 1 détecte un serrage défectueux d'un câble de phase Ci au niveau de la borne d'entrée Ui associée. Ce qui va être expliqué est valable pour chacune des phases Ph1, Ph2 et Ph3.

Lorsque que le câble de phase Ci est correctement serré au niveau de la borne d'entrée Ui, la borne d'entrée Ui présente une impédance dont un ordre de grandeur est typiquement égal à 1mΩ. Lorsque le câble de phase Ci est mal serré ou desserré, la borne d'entrée Ui présente une impédance dont un ordre de grandeur est typiquement égal à 10mΩ.

Pour une même tension source Vphi (fournie par le réseau 2 en amont de la borne d'entrée Ui), lorsque le courant source Iphi passe d'une valeur faible à une valeur élevée, la tension d'entrée Ve mesurée par le compteur 1 (en aval de la borne d'entrée Ui) varie donc de manière différente selon que le câble de phase Ci est ou non correctement serré.

Lorsque le câble de phase Ci est correctement serré, la variation de tension est faible, alors que lorsque le câble de phase est mal serré, la variation de tension est élevée.

Ainsi, pour une tension source de 230VRMS, lorsque le câble de phase Ci est correctement serré au niveau de la borne d'entrée Ui, la tension d'entrée Ve subit une diminution de l'ordre de 0,04VRMS alors que, lorsque le câble de phase Ci est mal serré au niveau de la borne d'entrée Ui, la tension d'entrée Ve subit une diminution supérieure ou égale à 0,4VRMS.

Le microcontrôleur 11 acquiert donc les mesures de courant et les mesures de tension, et tente de détecter une séquence prédéfinie comprenant une première période, au cours de laquelle le courant source Iphi est inférieur à un premier seuil de courant prédéfini, et une deuxième période, au cours de laquelle le courant source Iphi est supérieur à un deuxième seuil de courant prédéfini, qui est supérieur au premier seuil prédéfini.

Le premier seuil de courant prédéfini SI1 est typiquement compris entre 2,5A et 7,5A, et est ici égal à 5A. Le premier seuil de courant prédéfini SI1 est programmable.

Le deuxième seuil de courant prédéfini SI2 est typiquement compris entre 20A et 60A, et est ici égal à 40A. Le deuxième seuil de courant prédéfini SI2 est programmable.

Le microcontrôleur 11 acquiert, pour chaque séquence prédéfinie, au moins une première mesure de tension pendant la première période et au moins une deuxième mesure de tension pendant la deuxième période.

Le microcontrôleur 11 détecte un serrage défectueux du câble de phase Ci au niveau de la borne d'entrée Ui lorsque, pour au moins une séquence prédéfinie, au moins une valeur de détection représentative d'une différence entre une première mesure de tension et une deuxième mesure de tension est supérieure ou égale à un seuil de tension. La valeur de détection est ici égale à cette différence.

Le seuil de tension SV est typiquement compris entre 0,2VRMS et 0,6VRMS, et est ici égal à 0,4VRMS. Le seuil de tension SV est programmable.

On note que la précision de mesure des tensions RMS dans un compteur est classiquement inférieure ou égale à 0.1% (ce qui correspond à 0,2VRMS à 230V).

Le microcontrôleur 11 confirme ici la détection du serrage défectueux sur plusieurs mesures.

Le microcontrôleur 11 détecte le serrage défectueux lorsqu'un premier nombre prédéfini d'une pluralité de valeurs de détection, obtenues au cours d'une même séquence prédéfinie, sont supérieures au seuil de tension.

Le premier nombre prédéfini est ici égal à trois.

Plus précisément, le microcontrôleur 11 acquiert (au moins) une première mesure de tension au cours de la première période, puis (au moins) trois deuxièmes mesures de tension au cours de la deuxième période. Le microcontrôleur 11 calcule (au moins) trois valeurs de détection égales chacune à une différence entre une deuxième mesure de tension et la première mesure de tension, et détecte un serrage défectueux au niveau de la borne d'entrée Ui lorsqu'au moins trois valeurs de détection sont supérieures au seuil de tension. La détection du serrage défectueux est donc confirmée sur trois secondes consécutives.

Alternativement, le microcontrôleur 11 peut détecter le serrage défectueux lorsque plusieurs valeurs de détection, obtenues pour un deuxième nombre prédéfini de séquences prédéfinies successives, sont supérieures au seuil de tension.

Le deuxième nombre prédéfini est ici égal à trois. La détection du serrage défectueux est donc confirmée sur trois séquences prédéfinies successives.

On note que le microcontrôleur 11 détecte une séquence prédéfinie lorsqu'une durée séparant la première période de la deuxième période est inférieure à un seuil temporel prédéfini.

En effet, pour que les critères s'appliquent, le laps de temps qui s'écoule entre la fin d'une période de courant faible (première période) et le début d'une période de courant fort (deuxième période) doit être inférieure à un seuil temporel prédéfini, afin que l'on puisse considérer que la tension source en amont du compteur 1 ne varie pas de manière significative entre la période de courant faible et la période de courant fort.

Le seuil temporel prédéfini T est typiquement compris entre 30s et 90s, et est ici égal à 60s. Le seuil temporel prédéfini T est programmable.

On a vu précédemment que le seuil de tension SV est programmable et est par exemple égal à 0,4VRMS, c'est-à-dire à une valeur constante.

Alternativement, le seuil de tension SV peut dépendre de la première mesure de courant (réalisée au cours de la première période) et de la deuxième mesure de courant (réalisée au cours de la deuxième période).

On a par exemple :

$$SV = a*(I2-I1),$$

où SV est le seuil de tension et a est un paramètre, I1 est la première mesure de courant réalisée au cours de la première période et I2 est la deuxième mesure de courant réalisée au cours de la deuxième période. Bien sûr, si plusieurs mesures sont réalisées au cours de chaque période, I1 et I2 sont obtenues à partir desdites mesures (par exemple par moyennage). Avantageusement, la première mesure de courant et la deuxième mesure de courant sont chacune obtenues à partir d'au moins deux mesures successives stables (stabilité du courant sur au moins deux secondes).

Le paramètre a est programmable.

Le paramètre a peut être défini en fonction du premier seuil de courant prédéfini et du deuxième seuil de courant prédéfini.

Ici, on a par exemple :

$$a = 0,4/(IS2-IS1)$$
$$= 0,4/(40-5) = 0,01142857.$$

On note aussi que la détection d'un serrage défectueux est considérée comme valide si et seulement si il n'y a pas d'anomalie sur la tension source Vphi pendant les mesures (pas d'affaissement de tension, ni de coupure même brève, ni de surtension).

Lorsque le microcontrôleur 11 détecte un serrage défectueux sur la borne d'entrée Ui, le microcontrôleur 11 affiche sur l'écran LCD du compteur 1, à destination de l'installateur, un message d'alarme.

Le message d'alarme est aussi envoyé au SI du gestionnaire du réseau (SI pour « Système d'Information »).

Le microcontrôleur 11 coopère, pour remonter les messages d'alarme, avec des moyens de communication intégrés dans le compteur 1. Les moyens de communication 1 mettent par exemple en oeuvre une communication par courants porteurs en ligne (utilisant par exemple le standard CPL-G3), ou une communication radio sur un réseau cellulaire (utilisant par exemple le protocole LTE-M ou le protocole NB-IoT), ou toute autre technologie permettant d'établir une communication à distance.

Lorsque le microcontrôleur 1 détecte des serrages défectueux d'un ou de deux câbles de phase Ci au niveau de la ou des bornes d'entrée Ui associées, le microcontrôleur 11 localise un serrage défectueux réel au niveau de chacune desdites bornes d'entrée Ui.

Par contre, lorsque le microcontrôleur 11 détecte simultanément des serrages défectueux des trois câbles de phase Ci au niveau des trois bornes d'entrée Ui, le microcontrôleur 11 corrige la localisation de l'anomalie et localise un serrage défectueux réel au niveau de la borne d'entrée UN connectée au câble de neutre CN (et non au niveau des bornes d'entrée Ui reliées aux câbles de phase Ci).

Ainsi, le message d'alarme contient à la fois une indication selon laquelle au moins un serrage défectueux est détecté, et une indication localisant le ou les serrages défectueux au niveau d'une ou de bornes d'entrée particulières.

Avantageusement, la fonction de détection du serrage défectueux est « débrayable », c'est-à-dire qu'elle peut être désactivée (et réactivée) soit localement, par exemple par l'installateur (via un bouton prévu sur le compteur 1 à cet effet, ou via tout autre type d'interface homme-machine), soit à distance, par exemple sur ordre du gestionnaire du réseau (et par exemple via les moyens de communication précédemment évoqués).

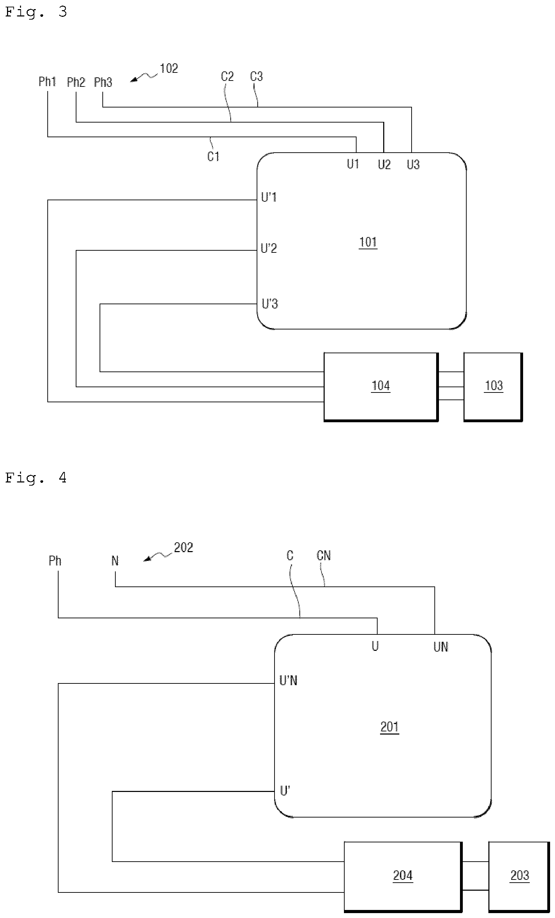

On voit sur la figure 3 un compteur électrique 101 selon un deuxième mode de réalisation de l'invention. Le compteur 101 est un compteur triphasé, agencé selon une configuration en trois fils.

Le réseau de distribution 102 comporte trois phases Ph1, Ph2, Ph3.

Un disjoncteur 104 est positionné à la frontière entre le réseau de distribution 102 et l'installation de l'abonné 103.

Le compteur comprend trois bornes d'entrée U1, U2, U3 connectées chacune à l'une des phases via un câble de phase C1, C2, C3, et trois bornes de sortie U'1, U'2, U'3 connectées au disjoncteur 104.

Le schéma de la figure 2 est applicable au compteur 101, pour chacune des phases.

On voit sur la figure 4 un compteur électrique 201 selon un troisième mode de réalisation de l'invention. Le compteur 201 est un compteur monophasé.

Le réseau de distribution 202 comporte une phase Ph et un neutre N. Le compteur 201 comprend deux bornes d'entrée U et UN, l'une reliée à la phase Ph et l'autre au neutre N, et deux bornes de sortie U' et U'N.

Un disjoncteur 204 est positionné à la frontière entre le réseau de distribution 202 et l'installation de l'abonné 203.

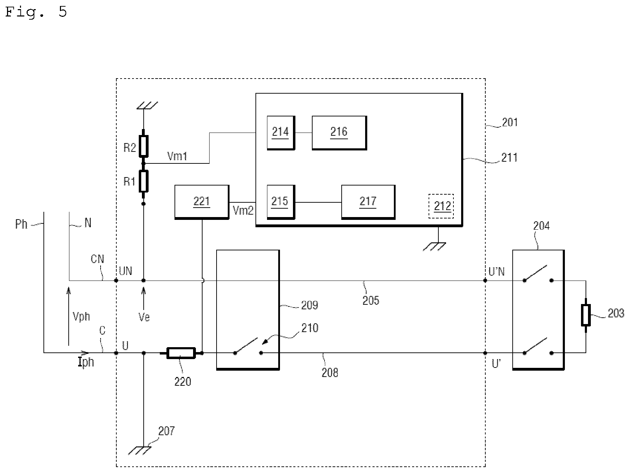

En référence à la figure 5, le schéma électrique du compteur 201 est proche de celui de la figure 2.

On retrouve ainsi la plupart des éléments présents sur la figure 2, dont les références sur la figure 5 sont incrémentées de 200.

Cette fois, cependant, le conducteur de phase 208 est relié à la masse électrique 207. La tension d'entrée Ve est mesurée sur le conducteur de neutre 205, c'est-à-dire que la première résistance de mesure R1 a une première borne reliée au conducteur de neutre 205. Le capteur de courant est cette fois un *shunt* 220 monté sur le conducteur de phase 208, en ayant une première borne reliée à la borne d'entrée U et une deuxième borne reliée à l'organe de coupure 209.

Le microcontrôleur 211 détecte un serrage défectueux à partir des mesures de tension produites par le capteur de tension et des mesures de courant produites par le capteur de courant.

Lorsque le microcontrôleur 211 détecte un serrage défectueux, il localise le serrage défectueux sur l'ensemble des bornes d'entrée (c'est-à-dire que le serrage défectueux peut être au niveau de la borne d'entrée P, de la borne d'entrée N, ou des deux bornes d'entrée).

Bien entendu, l'invention n'est pas limitée aux modes de réalisation décrits mais englobe toute variante entrant dans le champ de l'invention telle que définie par les revendications.

Dans chaque séquence prédéfinie détectée, la première période (courant faible) peut précéder la deuxième période (courant fort), mais ce n'est pas nécessairement le cas.

Les séquences prédéfinies peuvent être des séquences dans lesquelles la première période précède la seconde période, ou bien des séquences dans lesquelles la seconde période précède la première période, ou bien des séquences comprenant une première période et une seconde période, quel que soit l'ordre dans lequel celles-ci surviennent.

Si la première période précède la deuxième période, le microcontrôleur détecte une baisse anormale de la tension d'entrée en cas de serrage défectueux ; si la deuxième période précède la première période, le microcontrôleur détecte une hausse anormale de la tension d'entrée en cas de serrage défectueux.

La source, qui fournit l'énergie électrique mesurée par le compteur, n'est pas nécessairement le réseau de distribution en amont du compteur.

La source pourrait aussi être l'installation d'un abonné en aval du compteur. L'installation est alors non plus « consommatrice » mais « productrice », et fournit de l'énergie au réseau.

L'invention est alors mise en oeuvre de la même manière, si ce n'est que les bornes d'entrée sont les bornes U'1, U'2, U'3 et éventuellement U'N dans le cas du compteur triphasé, ou bien U' et U'N dans le cas du compteur monophasé.

Dans le cas monophasé, le serrage défectueux est localisé soit au niveau de la borne d'entrée U', soit au niveau de la borne d'entrée U'N, soit au niveau des deux bornes d'entrée.

Dans le cas triphasé avec neutre, le serrage défectueux est localisé sur une ou deux bornes d'entrée U'i (i variant de 1 à 3) lorsqu'une ou deux des phases sont en défaut, et lorsque les trois phases sont en défaut, le serrage défectueux est localisé sur la borne d'entrée U'N.

On considère, dans le cas de l'installation productrice, que l'impédance amenée par l'organe de coupure est négligeable (de l'ordre de quelques 100$\mu\Omega$, et 500$\mu\Omega$ maximum).

L'architecture du compteur pourrait bien sûr être différente de celle décrite ici.

On a décrit que deux CANs sont intégrés dans le microcontrôleur. Il est cependant possible d'utiliser un unique CAN intégré dans le microcontrôleur.

Le ou les CANs peuvent aussi être un ou des CANs externes au microcontrôleur.

Le microcontrôleur dans lequel est mis en oeuvre le procédé de détection n'est pas nécessairement le microcontrôleur de métrologie mais pourrait être un composant distinct, et par exemple le microcontrôleur application de la partie applicative.

Plus généralement, le procédé de détection peut être mis en oeuvre dans une unité de traitement comprenant au moins un composant de traitement et des mémoires. Le composant de traitement n'est pas nécessairement un microcontrôleur, mais pourrait être un composant différent, et par exemple un processeur classique, un DSP (pour *Digital Signal Processor*, que l'on peut traduire par « processeur de signal numérique »), ou bien un circuit logique programmable tel qu'un FPGA (pour *Field Programmable Gate Arrays*) ou un ASIC (pour *Application Spécifie Integrated Circuit*).

## Revendications

1. Compteur électrique (1), agencé pour mesurer une énergie électrique fournie par une source (2), comportant :

> - au moins une borne d'entrée (Ui), chaque borne d'entrée étant agencée pour être connectée à la source par un câble (Ci) ;
> - au moins un capteur de tension et au moins un capteur de courant agencés pour produire respectivement, depuis l'intérieur du compteur électrique, des mesures de tension pour évaluer une tension source (Vphi) fournie par la source, et des mesures de courant pour évaluer un courant source (Iphi) fourni par la source ;
> - une unité de traitement (11) agencée pour :
>
> > o acquérir les mesures de tension et les mesures de courant, et détecter au moins une séquence prédéfinie comprenant une première période, au cours de laquelle le courant source est inférieur à un premier seuil de courant prédéfini, et une deuxième période, au cours de laquelle le courant source est supérieur à un deuxième seuil de courant prédéfini, qui est supérieur au premier seuil de courant prédéfini ;
> > o acquérir, pour chaque séquence prédéfinie, au moins une première mesure de tension pendant la première période et au moins une deuxième mesure de tension pendant la deuxième période ;
> > o détecter un serrage défectueux d'au moins un câble au niveau de la borne d'entrée connectée audit câble lorsque, pour au moins une séquence prédéfinie, au moins une valeur de détection représentative d'une différence entre une première mesure de tension et une deuxième mesure de tension est supérieure ou égale à un seuil de tension.

2. Compteur électrique selon la revendication 1, dans lequel l'unité de traitement (11) est agencée pour détecter une séquence prédéfinie seulement lorsqu'une durée séparant la première période de la deuxième période est inférieure à un seuil temporel prédéfini.

3. Compteur électrique selon l'une des revendications précédentes, dans lequel le seuil de tension est défini en fonction d'une première mesure de courant réalisée au cours de la première période et d'une deuxième mesure de courant réalisée au cours de la deuxième période.

4. Compteur électrique selon la revendication 3, dans lequel on a :

$$SV = a*(I2-I1),$$

où SV est le seuil de tension, a est un paramètre, I1 est la première mesure de courant réalisée au cours de la première période et I2 est la deuxième mesure de courant réalisée au cours de la deuxième période.

5. Compteur électrique selon la revendication 4, dans lequel le paramètre a est défini en fonction du premier seuil de courant prédéfini et du deuxième seuil de courant prédéfini.

6. Compteur électrique selon l'une des revendications précédentes, dans lequel l'unité de traitement (11) est agencée pour détecter le serrage défectueux lorsqu'un premier nombre prédéfini d'une pluralité de valeurs de détection, obtenues au cours d'une même séquence prédéfinie, sont supérieures au seuil de tension.

7. Compteur électrique selon l'une des revendications 1 à 5, dans lequel l'unité de traitement (11) est agencée pour détecter le serrage défectueux lorsque plusieurs valeurs de détection, obtenues pour un deuxième nombre prédéfini de séquences prédéfinies successives, sont supérieures au seuil de tension.

8. Compteur électrique selon l'une des revendications précédentes, dans lequel le premier seuil de courant prédéfini est compris entre 2,5A et 7,5A, et le deuxième seuil de courant prédéfini est compris entre 20A et 60A.

9. Compteur électrique selon l'une des revendications précédentes, la source (2) comprenant trois phases (Ph1, Ph2, Ph3), le compteur électrique (1) étant un compteur triphasé comprenant trois bornes d'entrée (U1, U2, U3) agencées pour être connectées chacune à une phase via un câble de phase (C1, C2, C3), le compteur électrique comprenant, pour chaque câble de phase, un capteur de tension agencé pour produire des mesures de tension pour évaluer la tension source présente sur ledit câble de phase, et un capteur de courant agencé pour produire des mesures de courant pour évaluer le courant source circulant sur ledit câble de phase, l'unité de traitement étant agencée, pour chaque câble de phase, pour détecter un serrage défectueux dudit câble de phase au niveau de la borne d'entrée connectée audit câble de phase à partir des mesures de tension et des mesures de courant produites par le capteur de tension et le capteur de courant associés.

10. Compteur électrique selon la revendication 9, la source comprenant en outre un neutre, le compteur électrique comprenant en outre une borne d'entrée agencée pour être connectée au neutre via un câble de neutre, l'unité de traitement étant agencée pour :

- lorsqu'elle détecte un ou des serrages défectueux d'un ou de deux câbles de phase au niveau de la ou des bornes d'entrée connectées audit ou auxdits câbles de phase, localiser un serrage défectueux réel au niveau de ladite ou desdites bornes d'entrée ;
- lorsqu'elle détecte simultanément des serrages défectueux des trois câbles de phase au niveau des trois bornes d'entrée connectées auxdits câbles de phase, localiser un serrage défectueux réel au niveau de la borne d'entrée connectée au câble de neutre.

11. Compteur électrique selon l'une des revendications 1 à 8, la source comprenant une phase et un neutre, le compteur électrique étant un compteur monophasé comprenant une borne d'entrée agencée pour être connectée à la phase par un câble de phase et une borne d'entrée agencée pour être connectée au neutre par un câble de neutre, le compteur électrique comprenant un capteur de tension agencé pour produire des mesures de tension pour évaluer la tension source présente sur ledit câble de neutre, et un capteur de courant agencé pour produire des mesures de courant pour évaluer le courant source circulant sur ledit câble de phase, l'unité de traitement étant agencée pour détecter un serrage défectueux à partir des mesures de tension produites par le capteur de tension et des mesures de courant produites par le capteur de courant.

12. Compteur électrique selon l'une des revendications précédentes, la source étant un réseau de distribution d'énergie électrique.

13. Compteur électrique selon l'une des revendications 1 à 11, la source étant une installation d'un abonné productrice d'énergie électrique.

14. Procédé de détection, mis en oeuvre par une unité de traitement d'un compteur électrique selon l'une des revendications précédentes, et comprenant les étapes de :

o acquérir les mesures de tension et les mesures de courant, et détecter au moins une séquence prédéfinie comprenant une première période, au cours de laquelle le courant source est inférieur à un premier seuil de courant prédéfini, et une deuxième période, au cours de laquelle le courant source est supérieur à un deuxième seuil de courant prédéfini, qui est supérieur au premier seuil de courant prédéfini ;
o acquérir, pour chaque séquence prédéfinie, au moins une première mesure de tension pendant la première période et au moins une deuxième mesure de tension pendant la deuxième période ;
o détecter un serrage défectueux d'au moins un câble au niveau de la borne d'entrée connectée audit câble lorsque, pour au moins une séquence prédéfinie, au moins une valeur de détection représentative d'une différence entre une première mesure de tension et une deuxième mesure de tension est supérieure ou égale à un seuil de tension prédéfini.

15. Programme d'ordinateur comprenant des instructions qui conduisent l'unité de traitement du compteur électrique selon l'une des revendications 1 à 13 à exécuter les étapes du procédé de détection selon la revendication 14.

16. Support d'enregistrement lisible par ordinateur, sur lequel est enregistré le programme d'ordinateur selon la revendication 15.

**Patentansprüche**

1. Stromzähler (1), der ausgebildet ist, eine von einer Quelle (2) gelieferte elektrische Energie zu messen, umfassend:

- mindestens eine Eingangsklemme (Ui), wobei jede Eingangsklemme ausgebildet ist, über ein Kabel (Ci) mit der Quelle verbunden zu werden;
- mindestens einen Spannungssensor und mindestens einen Stromsensor, die ausgebildet sind, aus dem Inneren des Stromzählers heraus Spannungsmessungen zum Evaluieren einer von der Quelle gelieferten Quellspannung (Vphi) bzw. Strommessungen zum Evaluieren eines von der Quelle gelieferten Quellstroms (Iphi) durchzuführen;
- eine Verarbeitungseinheit (11), die ausgebildet ist, um:

o die Spannungsmessungen und die Strommessungen zu erfassen und mindestens eine vordefinierte Sequenz zu detektieren, die eine erste Periode umfasst, während der der Quellstrom niedriger als ein erster vordefinierter Stromschwellenwert ist, und eine zweite Periode, während der der Quellstrom größer als ein zweiter vordefinierter Stromschwellenwert ist, der größer als der erste vordefinierte Stromschwellenwert ist;

o für jede vordefinierte Sequenz mindestens eine erste Spannungsmessung während der ersten Periode und mindestens eine zweite Spannungsmessung während der zweiten Periode zu erfassen;

o ein fehlerhaftes Festklemmen mindestens eines Kabels im Bereich der Eingangsklemme, die mit dem genannten Kabel verbunden ist, zu detektieren, wenn für mindestens eine vordefinierte Sequenz mindestens ein Detektionswert, der repräsentativ für eine Differenz zwischen einer ersten Spannungsmessung und einer zweiten Spannungsmessung ist, größer oder gleich einem Spannungsschwellenwert ist.

2. Stromzähler nach Anspruch 1, bei dem die Verarbeitungseinheit (11) ausgebildet ist, eine vordefinierte Sequenz nur zu detektieren, wenn eine Dauer, die die erste Periode von der zweiten Periode trennt, kürzer als ein vordefinierter Zeitschwellenwert ist.

3. Stromzähler nach einem der vorhergehenden Ansprüche, bei dem der Spannungsschwellenwert in Abhängigkeit von einer ersten Strommessung definiert ist, die während der ersten Periode durchgeführt wird, und einer zweiten Strommessung, die während der zweiten Periode durchgeführt wird.

4. Stromzähler nach Anspruch 3, bei dem gilt:

$$SV = a * (I2 - I1),$$

wobei SV der Spannungsschwellenwert ist, a ein Parameter ist, I1 die erste Strommessung ist, die während der ersten Periode durchgeführt wird, und I2 die zweite Strommessung ist, die während der zweiten Periode durchgeführt wird.

5. Stromzähler nach Anspruch 4, bei dem der Parameter a in Abhängigkeit von dem ersten vordefinierten Stromschwellenwert und dem zweiten vordefinierten Stromschwellenwert definiert ist.

6. Stromzähler nach einem der vorhergehenden Ansprüche, bei dem die Verarbeitungseinheit (11) ausgebildet ist, das fehlerhafte Festklemmen zu detektieren, wenn eine erste vordefinierte Anzahl einer Vielzahl von Detektionswerten, die während einer selben vordefinierten Sequenz erhalten werden, über dem Spannungsschwellenwert liegt.

7. Stromzähler nach einem der Ansprüche 1 bis 5, bei dem die Verarbeitungseinheit (11) ausgebildet ist, das fehlerhafte Festklemmen zu detektieren, wenn mehrere Detektionswerte, die für eine zweite vordefinierte Anzahl von aufeinanderfolgenden vordefinierten Sequenzen erhalten werden, über dem Spannungsschwellenwert liegen.

8. Stromzähler nach einem der vorhergehenden Ansprüche, bei dem der erste vordefinierte Stromschwellenwert zwischen 2,5 A und 7,5 A liegt und der zweite vordefinierte Stromschwellenwert zwischen 20 A und 60 A liegt.

9. Stromzähler nach einem der vorhergehenden Ansprüche, wobei die Quelle (2) drei Phasen (Ph1, Ph2, Ph3) umfasst, wobei der Stromzähler (1) ein Dreiphasenzähler ist, der drei Eingangsklemmen (U1, U2, U3) umfasst, die ausgebildet sind, jeweils über ein Phasenkabel (C1, C2, C3) mit einer Phase verbunden zu werden, wobei der Stromzähler für jedes Phasenkabel einen Spannungssensor umfasst, der ausgebildet ist, Spannungsmessungen durchzuführen, um die Quellspannung, die auf dem Phasenkabel vorhanden ist, zu evaluieren, und einen Stromsensor, der ausgebildet ist, Strommessungen durchzuführen, um den Quellstrom, der auf dem Phasenkabel fließt, zu evaluieren, wobei die Verarbeitungseinheit ausgebildet ist, für jedes Phasenkabel ein fehlerhaftes Festklemmen des Phasenkabels im Bereich der Eingangsklemme, die mit dem Phasenkabel verbunden ist, anhand der Spannungsmessungen und der Strommessungen, die von dem dazugehörigen Spannungssensor und dem dazugehörigen Stromsensor durchgeführt werden, zu detektieren.

10. Stromzähler nach Anspruch 9, wobei die Quelle ferner einen Neutralleiter umfasst, wobei der Stromzähler ferner eine Eingangsklamme umfasst, die ausgebildet ist, über ein Neutralkabel mit dem Neutralleiter verbunden zu werden, wobei die Verarbeitungseinheit ausgebildet ist, um:

- wenn sie eine oder mehrere fehlerhafte Festklemmungen eines oder zweier Phasenkabel im Bereich der Eingangsklemme(n), die mit dem oder den genannten Phasenkabeln verbunden sind, detektiert, Lokalisieren eines realen fehlerhaften Festklemmens im Bereich der genannten Eingangsklemme(n);
- wenn sie gleichzeitig fehlerhafte Festklemmungen von drei Phasenkabeln im Bereich der drei Eingangsklemmen detektiert, die mit den Phasenkabeln verbunden sind, Lokalisieren eines realen fehlerhaften Festklemmens im Bereich der Eingangsklemme, die mit dem Neutralkabel verbunden ist.

11. Stromzähler nach einem der Ansprüche 1 bis 8, wobei die Quelle eine Phase und einen Neutralleiter umfasst, wobei der Stromzähler ein Einphasenzähler ist, der eine Eingangsklemme umfasst, die ausgebildet ist, über ein Phasenkabel mit der Phase verbunden zu werden, und eine Eingangsklemme, die ausgebildet ist, über ein Neutralkabel mit dem Neutralleiter verbunden zu werden, wobei der Stromzähler einen Spannungssensor umfasst, der ausgebildet ist, Spannungsmessungen durchzuführen, um die Quellspannung, die auf dem genannten Neutralkabel vorhanden ist, zu evaluieren, und einen Stromsensor, der ausgebildet ist, Strommessungen durchzuführen, um den Quellstrom, der auf dem genannten Phasenkabel fließt, zu evaluieren, wobei die Verarbeitungseinheit ausgebildet ist, ein fehlerhaftes Festklemmen anhand der von dem Spannungssensor durchgeführten Spannungsmessungen und der von dem Stromsensor durchgeführten Strommessungen zu detektieren.

12. Stromzähler nach einem der vorhergehenden Ansprüche, wobei die Quelle ein Verteilungsnetz für elektrische Energie ist.

13. Stromzähler nach einem der Ansprüche 1 bis 11, wobei die Quelle eine Anlage eines Abonnenten ist, der elektrische Energie erzeugt.

14. Detektionsverfahren, durchgeführt von einer Verarbeitungseinheit eines Stromzählers nach einem der vorhergehenden Ansprüche, und umfassend die Schritte:

o Erfassen der Spannungsmessungen und der Strommessungen und Detektieren von mindestens einer vordefinierten Sequenz, die eine erste Periode umfasst, während der der Quellstrom niedriger als ein erster vordefinierter Stromschwellenwert ist, und eine zweite Periode, während der der Quellstrom größer als ein zweiter vordefinierter Stromschwellenwert ist, der größer als der erste vordefinierte Stromschwellenwert ist;

o Erfassen für jede vordefinierte Sequenz mindestens einer ersten Spannungsmessung während der ersten Periode und mindestens einer zweiten Spannungsmessung während der zweiten Periode;

o Detektieren eines fehlerhaften Festklemmens mindestens eines Kabels im Bereich der Eingangsklemme, die mit dem genannten Kabel verbunden ist, wenn für mindestens eine vordefinierte Sequenz mindestens ein Detektionswert, der repräsentativ für eine Differenz zwischen einer ersten Spannungsmessung und einer zweiten Spannungsmessung ist, größer oder gleich einem vordefinierten Spannungsschwellenwert ist.

15. Computerprogramm, umfassend Anweisungen, die die Verarbeitungseinheit des Stromzählers nach einem der Ansprüche 1 bis 13 dazu veranlassen, die Schritte des Detektionsverfahrens nach Anspruch 14 auszuführen.

16. Computerlesbarer Aufzeichnungsträger, auf dem das Computerprogramm nach Anspruch 15 gespeichert ist.

**Claims**

1. An electricity meter (1), arranged to measure electrical energy supplied by a source (2), the electricity meter comprising:

· at least one input terminal (Ui), each input terminal being arranged to be connected to the source by a respective wire (Ci);
· at least one voltage sensor and at least one current sensor arranged to act from inside the electricity meter to take voltage measurements to evaluate a source voltage (Vphi) supplied by the source, and current measurements for evaluating a source current (Iphi) supplied by the source;
· a processor unit (11) arranged:

o to acquire the voltage measurements and the current measurements, and to detect at least one predefined sequence comprising a first period during which the source current is less than a first predefined current threshold, and a second period during which the source current is greater than a second predefined current threshold that is itself greater than the first predefined current threshold;
o for each predefined sequence, to acquire at least one first voltage measurement during the first period and at least one second voltage measurement during the second period;
o to detect faulty clamping between at least one wire and the input terminal that is connected to said wire when, during at least one predefined sequence, at least one detection value representative of a difference between a first voltage measurement and a second voltage measurement is greater than or equal to a voltage threshold.

2. An electricity meter according to claim 1, wherein the processor unit (11) is arranged to detect a predefined sequence only when the duration between the first period and the second period is less than a predefined time threshold.

3. An electricity meter according to either preceding claim, wherein the voltage threshold is defined as a function both of a first current measurement taken during the first period and also of a second current measurement taken during the second period.

4. An electricity meter according to claim 3, wherein the following applies:

$$SV = a*(I2-I1);$$

where SV is the voltage threshold, a is a parameter, I1 is the first current measurement taken during the first period, and I2 is the second current measurement taken during the second period.

5. An electricity meter according to claim 4, wherein the parameter a is defined as a function both of the first predefined current threshold and also of the second predefined current threshold.

6. An electricity meter according to any preceding claim, wherein the processor unit (11) is arranged to act over a single predefined sequence to obtain a plurality of detection values, and to detect faulty clamping when the number of those detection values that are greater than the voltage threshold reaches a first predefined number.

7. An electricity meter according to any one of claims 1 to 5, wherein the processor unit (11) is arranged to act over a plurality of successive predefined sequences to obtain detection values, the number of successive sequences being a second predefined number, and to detect faulty clamping when a plurality of those detection values are greater than the voltage threshold.

8. An electricity meter according to any preceding claim, wherein the first predefined current threshold lies in the range 2.5 A to 7.5 A, and the second predefined current threshold lies in the range 20 A to 60 A.

9. An electricity meter according to any preceding claim, the source (2) comprising three phase lines (Ph1, Ph2, Ph3), the electricity meter (1) being a three-phase meter including three input terminals (U1, U2, U3), each arranged to be connected to a respective phase line via a respective phase wire (C1, C2, C3), the electricity meter including, for each phase wire, both a respective voltage sensor arranged to produce voltage measurements for evaluating the source voltage present on said phase wire and also a current sensor arranged to produce current measurements for evaluating the source current flowing in said phase wire, the processor unit being arranged, for each phase wire, to detect faulty clamping between said phase wire and the input terminal connected to said phase wire on the basis of the voltage measurements and of the current measurements produced by the voltage sensor and by the associated current sensor.

10. An electricity meter according to claim 9, the source also comprising a neutral line and the electricity meter also including an input terminal arranged to be connected to the neutral line via a neutral wire, the processor unit being arranged:

· when it detects faulty clamping between one or two phase wires and the corresponding input terminal(s) connected to said phase wire(s), to determine that the faulty clamping is in reality located at said input terminal(s);
· when it detects simultaneous faulty clamping between all three phase wires and the three corresponding input terminals connected to said phase wires, to determine that the faulty clamping is in reality located at the input terminal connected to the neutral wire.

11. An electricity meter according to any one of claims 1 to 8, the source comprising one phase line and one neutral line, the electricity meter being a single-phase meter including an input terminal arranged to be connected to the phase line by a phase wire and an input terminal arranged to be connected to neutral line by a neutral wire, the electricity meter including a voltage sensor arranged to produce voltage measurements for evaluating the source voltage present on said neutral wire, and a current sensor arranged to produce current measurements for evaluating the source current flowing in said phase wire, the processor unit being arranged to detect faulty clamping from the voltage measurements produced by the voltage sensor and from the current measurements produced by the current sensor.

12. An electricity meter according to any preceding claim, the source being a network for distributing electrical energy.

13. An electricity meter according to any one of claims 1 to 11, the source being a subscriber installation that produces electrical energy.

14. A detection method performed by a processor unit of an electricity meter according to any preceding claim, and comprising the steps of:

> · o acquiring the voltage measurements and the current measurements, and detecting at least one predefined sequence comprising a first period during which the source current is less than a first predefined current threshold, and a second period during which the source current is greater than a second predefined current threshold that is itself greater than the first predefined threshold;
> · o for each predefined sequence, acquiring at least one first voltage measurement during the first period and at least one second voltage measurement during the second period;
> · o detecting faulty clamping between at least one wire and the input terminal that is connected to said wire when, during at least one predefined sequence, at least one detection value representative of a difference between a first voltage measurement and a second voltage measurement is greater than or equal to a voltage threshold.

15. A computer program including instructions that cause the processor unit of the electricity meter according to any one of claims 1 to 13 to execute the steps of the detection method according to claim 14.

16. A computer-readable storage medium storing the computer program according to claim 15.

Fig. 1

Fig. 2

Fig. 3

Fig. 4

Fig. 5

**RÉFÉRENCES CITÉES DANS LA DESCRIPTION**

**Documents brevets cités dans la description**

- WO 2015179908 A

- EP 0430823 A